# EUROPEAN PATENT SPECIFICATION

(11) **EP 0 276 020 B1**
(45) Date of publication and mention of the grant of the patent: **12.11.1997**
(21) Application number: 88100963.3
(22) Date of filing: 22.01.1988
(51) Int. Cl.: H04N 3/15, G11C 27/04

(54) **Output stage for solid-state image pick-up device**
Ausgangsstufe für Festkörperbildaufnahmevorrichtung
Etage de sortie pour capteur d'image à l'état solide

(30) Priority: 22.01.1987 JP 11356/87; 22.01.1987 JP 11357/87
(43) Date of publication of application: 27.07.1988
(73) Proprietor: SONY CORPORATION, Tokyo 141 (JP)
(72) Inventor: Narabu, Tadakuni, Shinagawa-ku Tokyo (JP); Konda, Tetsuya, Shinagawa-ku Tokyo (JP); Maki, Yasuhito, Shinagawa-ku Tokyo (JP)
(74) Representative: Schmidt-Evers, Jürgen, Dipl.-Ing.

(56) References cited:
- EP-A- 0 169 740
- US-A- 3 983 409
- US-A- 4 352 070
- PROCEEDINGS OF THE "VMEbus IN PHYSICS CONFERENCE", CERN, Geneva, 7th - 8th october 1985, DATA HANDLING DIVISION, 30th January 1986, pages 155-168; D.R.N. JEFFERY et al.: "Use of a motorola 68000 VMEbus based system for fast read-out of a reticon photosensitive array"

## Description

The present invention relates generally to an improvement in and relating to an output stage of a solid-state image pick-up device , such as a charge-coupled device (CCD). More specifically, the invention relates to an output stage for a solid-state image pick-up device which is operable even at low voltage.

In the past, the image pick-up device, such as a CCD, is provided with a higher power source voltage in comparison with that in other semiconductor devices, such as a memory composed of a plurality of MOS transistors. As a typical output stage construction of the image pick-up device, an inverter circuit or a source follower circuit are employed. In the former case, the inverter circuit comprises a pair of first and second MOS transistors. The first MOS transistor has a gate to receive an output signal. The second transistor has a gate and drain connected to each other for forming an active load. An output signal is output between a drain of the first MOS transistor and the second MOS transistor.

In the inverter circuit as set forth above, the output level may not coincide with the input level. Therefore, when such an inverter circuit is combined with a low-pass filter, a sample/hold circuit and so forth, the source voltage has to be sufficiently high so as to avoid an influence by fluctuation of the output level. In addition, in such an inverter circuit, the circuit design becomes complicated which makes it difficult to design.

On the other hand, the conventional source follower circuit may comprise a pair of first and second MOS transistors. The first MOS transistor receives the input signal at its gate and outputs the output signal from its source. Such source follower circuit has a substantially small gain, e. g. less than or equal to 0dB. Therefore, when a plurality of source followers are connected to form multi-state source follower circuit the gain of such circuit becomes unacceptably small.

An output circuit according to the preamble of claim 1 is known from EP-A-0169740. The known circuit comprises a source follower circuit connected to the output of a charge-detect circuit and to the output of a clamp circuit which consists of a AC-coupled clamp capacitor, a clamp switch and a buffer amplifier. The buffer amplifier is shown as operational amplifier not being fed back. The clamp circuit is not very suitable for an improved output stage for a solid-state image pick-up because of varying voltage levels.

On the other hand, recently, there is a tendency to require an image pick-up device which is active at a lower power source voltage.

If the image pick-up device for low power source voltage operation is designed employing the conventional inverter circuit or the source follower circuit, the level margin becomes substantially small to cause malfunction when fluctuation in DC the level occurs.

Therefore, it is the object of the present invention to provide an improved output stage for a solid-state image pick-up device, such as a CCD, which is accurately operable even under a lower power source voltage.

The object is solved by the features of claim 1. The dependent claims comprise further developments of the invention.

The present invention will be understood more fully from the detailed description given herebelow and from the accompanying drawings of the preferred embodiment of the invention, which, however, should not be taken to limit the invention to the specific embodiment but are for explanation and understanding only.

In the drawings:
**Fig. 1** is a schematic and explanatory diagram showing the first embodiment of an output stage construction for a solid-state image pick-up device according to the invention;
**Fig. 2** is a schematic circuit diagram of a Burton circuit to be employed in the output stage circuit construction of Fig. 1;
**Fig. 3** is a detailed circuit diagram of the first embodiment of the output stage construction for the solid-state image pick-up device, of Fig. 1;
**Fig. 4** is a schematic and explanatory diagram showing the second embodiment of an output stage construction for a solid-state image pick-up device according to the invention;
**Fig. 5** is a detailed circuit diagram of the second embodiment of the output stage construction for the solid-state image pick-up device, of Fig 4;
**Fig. 6** is a schematic and explanatory diagramm showing the third embodiment of an output stage construction for a solid-state image pick-up device according to the invention; and
**Fig. 7** is a detailed circuit diagramm of the third embodiment of the output stage construction for the solid-state image pick-up device, of Fig. 6.

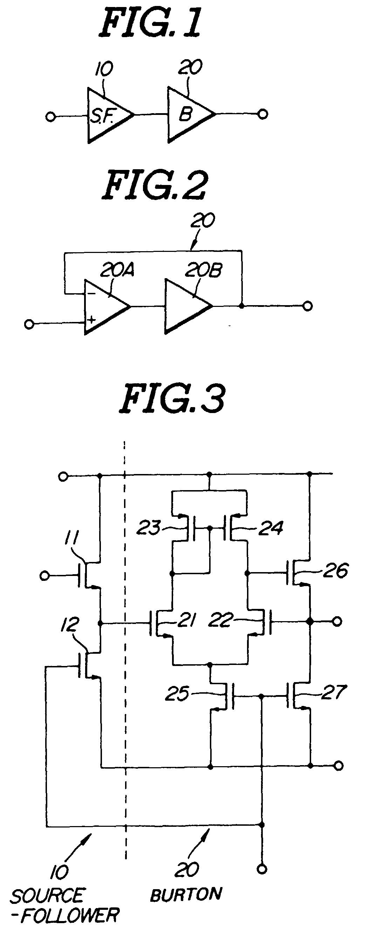

Referring now to the drawings, particularly to Figs. 1 to 3, the first embodiment of an output stage construction, according to the present invention, is composed of a source follower circuit 10 which serves as an amplifier circuit and a Burton circuit 20 as a buffer circuit. The source follower circuit 10 and the Burton circuit 20 are connected in series to form the output stage of the solid-state image pick-up device, i.e. a CCD. The source follower circuit 10 is connected to a floating gate of a CCD image pick-up device. The output section of the source follower circuit 10 is connected to the input section of the Burton circuit 20. The Burton circuit 20 is designed to output a constant DC level. The circuit layout of the source follower circuit 10 and the Burton circuit 20 as a series circuit makes it possible to suppress fluctuation of the DC level at the output.

Fig. 2 shows the Burton circuit 20. As seen from Fig. 2, the Burton circuit 20 comprises an operational amplifier 20A and a source follower 20B. The output of the source follower 20B is connected to the negative input terminal of the operational amplifier 20A to form a negative feedback circuit. With this construction, the Burton circuit 20 serves as a voltage follower having high input impedance and low output impedance. This suppresses fluctuation of the output DC level of the output stage of the CCD solid-state image pick-up device. With a fluctuation-suppressed output DC level, it becomes possible for a drive signal processing circuit to be connected to the next stage.

Fig. 3 shows practical circuit construction of the first embodiment of the output circuit of the solid-state image pick-up device, according to the invention. In the shown circuit construction, NMOS transistors 11 and 12 are arranged to form the source follower circuit 10. The NMOS transistors 11 and 12 are connected in series between the power source and the ground. The NMOS transistor 11 has a gate which forms an input section of the source follower circuit 10. Therefore, the gate of the NMOS transistor 11 is connected to the output section, such as a floating gate FG of the CCD solid-state image pick-up device in order to receive therefrom the input signal.

The NMOS transistor 11 also has a source which forms the output section of the source follower circuit 10. Therefore, the source of the NMOS transistor 11 is connected to the Burton circuit 20. As seen from Fig. 3, in the practical construction, the Burton circuit 20 has a NMOS transistor 21 having a gate connected to the source of the NMOS transistor 11. In this circuit layout, the NMOS transistor 12 serves as load.

The Burton circuit 20 serves as the buffer circuit as set forth above and has an differential stage serving as the operational amplifier 20A, and the source follower stage 20B. The arithmetic stage 20A comprises a pair of NMOS transistors 21 and 22 forming differential amplifier, a pair of PMOS transistor 23 and 24 connected to the pair of NMOS transistors 21 and 22 in current mirror fashion, and a NMOS transistor 25 which serves for supplying constant voltage. The source follower stage 20B is composed of a pair of NMOS transistor 26 and 27 connected between the power source and the ground.

The NMOS transistors 21 and 22 are active as the differential amplifier as set forth above, for the input on the gate of the NMOS transistor 21 to output an output signal from the drain of the NMOS transistor 22. The drain of the NMOS transistor 22 is connected to the gate of the NMOS transistor 26. The NMOS transistor 26 is responsive to the input through the gate to output the output signal from the source. The source of the NMOS transistor 26 is also connected to the gate of the NMOS transistor 22 as a negative feedback input. This source of the NMOS transistor 26 and the gate of the NMOS transistor 22 form the negative feedback loop.

With the circuit construction set forth above, the operational amplifier stage constituted of the NMOS transistors 21 and 22, PMOS transistors 23 and 24 and NMOS transistor 25, is formed as a voltage follower circuit or as an impedance converter circuit. Therefore, the gain at this operational amplifier stage becomes 1. Furthermore, because the operational amplifier serves as the voltage follower or the impedance converter, the output voltage becomes constant.

With this construction, the output impedance of the output circuit of the CCD solid-state image pick-up device can be successfully lowered since the Burton circuit 20 serving as a buffer amplifier can avoid the influence of the voltage fluctuation. Furthermore, as the nature of the buffer amplifier employed in the shown circuit construction which allows to regulate the output voltage, greater level margin can be given for the CCD solid-state image pick-up device. In other words, because a greater level margin can be given, lowering of the operation voltage level of the CCD solid-state image pick-up device becomes possible. Furthermore, since the output DC level can be held constant, circuit design with a fixed output voltage becomes possible to make designing easier. In addition, such circuit construction may give a wider signal dynamic range.

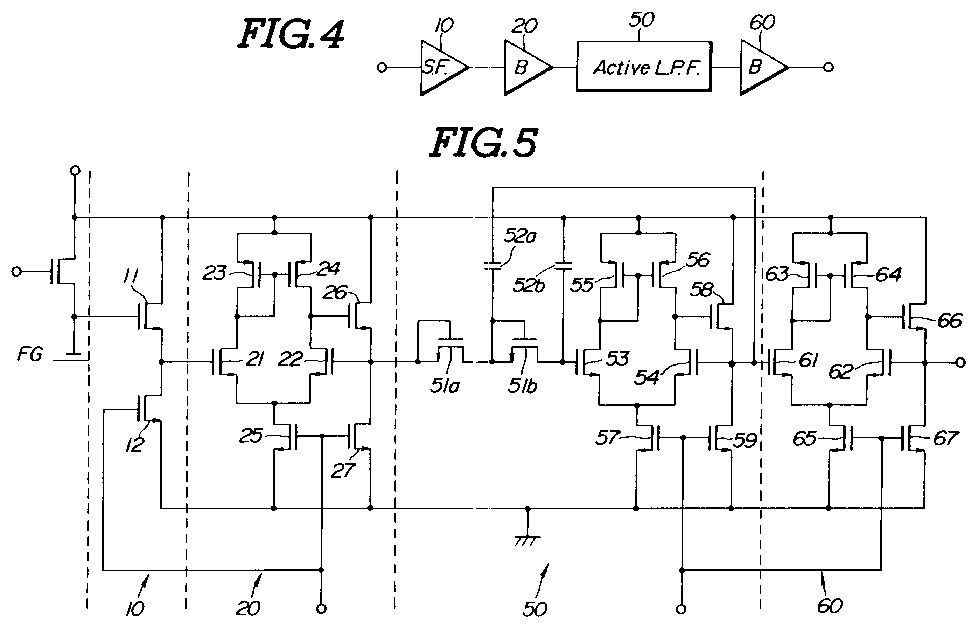

Figs. 4 and 5 show the second embodiment of the output stage construction of the CCD solid state image pick-up device, according to the present invention.

In the shown circuit construction, an active low-pass filter 50 and a Burton circuit 60 are connected in series to the series circuit of the source follower circuit 10 and Burton circuit 20. Therefore, the output of the CCD solid-state image pick-up device is received by the source follower circuit 10. The Burton circuit 20 is responsive to the output signal from the source follower circuit 10 to output the constant DC level output signal. The active low-pass filter circuit 50 filters out the high-frequency component of the output signal from the Burton circuit 20 and feeds to the Burton circuit 60 which serves as another buffer amplifier.

Namely, in the shown embodiment, the buffer amplifiers 20 and 60 which hold the output DC level constant and have a gain of precisely 1, are provided for suppressing fluctuation in the input and output DC level at the active low-pass filter circuit 50.

Fig. 5 shows the practical construction of the circuit in the second embodiment of the output stage for the CCD solid-state image pick-up device of Fig. 4. In the shown circuit construction of Fig. 5, the source follower circuit 10 and the Burton circuit 20 have sustantially identical circuit constructions to that discussed with respect to the foregoing first embodiment. Therefore, the discusssion of the circuit constructions and components in the source follower circuit 10 and Burton circuit 20 will be neglected and will be simply identified by the common reference numerals to that of the first embodiment, in order to avoid unnecessary redundancy in discussion and confusion in understanding.

The output of the Burton circuit 20, i.e. the source of the NMOS transistor 26, is connected to the active low-pass filter circuit 50. The active low-pass filter circuit 50 has the source of a MOS transistor 51a which serves as a resistor. The drain of the MOS transistor 51a is connected to the source of a MOS transistor 51b. The drain of the MOS transistor 51a is also connected to a capacitor 52a. The MOS transistor 51b and the capacitor 52a form a positive feedback loop. The drain of the MOS transistor 51b is connected to a capacitor 52b. As will be appreciated, these MOS transistors 51a and 51b and the capacitors 52a and 52b form a time constant circuit for determining the time constant characteristics of the active low-pass filter circuit 50.

The drain of the MOS transistor 51b is also connected to the gate of the NMOS transistor 53 of an operational amplifier circuit in the active low-pass filter circuit 50. The operational amplifier circuit comprises a pair of NMOS transistors 53 and 54 forming a differential amplifier, a pair of PMOS transistor 55 and 56 connected to the pair of NMOS transistors 53 and 54 in a current mirror fashion, and a NMOS transistor 57 which serves for supplying constant voltage. The source follower stage is composed of a pair of NMOS transistors 58 and 59 connected between the power source and the ground.

The NMOS transistors 53 and 54 are active as the differential amplifier as set forth above, on the input on the gate of the NMOS transistor 53 to output an output signal from the drain of the NMOS transistor 54. The drain of the NMOS transistor 54 is connected to the gate of the NMOS transistor 58. The NMOS transistor 58 is responsive to the input through the gate to output the ouput signal from the source. The source of the NMOS transistor 58 is also connected to the gate of the NMOS transistor 54 as negative feedback input. This source of the NMOS transistor 58 and the gate of the NMOS transistor 54 form the negative feedback loop.

With the circuit construction set forth above, the operational amplifier stage constituted of the NMOS transistors 53 and 54, PMOS transistors 55 and 56 and NMOS transistor 57, is formed as a voltage follower circuit or as an impedance converter circuit.
Therefore, the gain at this operational amplifier stage becomes 1. Furthermore, because of the operational amplifier serves as the voltage follower or the impedance converter, the output voltage becomes constant.

As shown in Fig. 5, a practical circuit construction of the Burton circuit 60 has substantially the same circuit construction as that of the foregoing Burton circuit 20 discussed in the foregoing first embodiment of Fig. 3. A NMOS transistor 61 having a gate connected to the source of the NMOS transistor 58 of the active low-pass filter circuit 50.

Similarly to the Burton circuit 20, the Burton circuit 60 serves as the buffer circuit as set forth above and has an arithmetic stage serving as the operational amplifier, and the source follower stage. The arithmetic stage comprises a pair of NMOS transistors 61 and 62 forming a differential amplifier, a pair of PMOS transistor 63 and 64 connected to the pair of NMOS transistors 61 and 62 in a current mirror fashion, and a NMOS transistor 65 which serves for supplying constant voltage. The source follower stage is composed of a pair of NMOS transistor 66 and 67 connected between the power source and the ground.

The NMOS transistors 61 and 62 are active as the differential amplifier as set forth above, on the input on the gate of the NMOS transistor 61 to output an output signal from the drain of the NMOS transistor 62. The drain of the NMOS transistor 62 is connected to the gate of the NMOS transistor 66. The NMOS transistor 66 is responsive to the input through the gate to output the output signal from the source. The source of the NMOS transistor 66 is also connected to the gate of the NMOS transistor 62 as negative feedback input. This source of the NMOS transistor 66 and the gate of the NMOS transistor 62 forms the negative feedback loop.

With the circuit construction set forth above, the operational amplifier stage constituted of the NMOS transistors 61 and 62, PMOS transistors 63 and 64 and NMOS transistor 65, is formed as voltage follower circuit or as an impedance converter circuit. Therefore, the gain at this operational amplifier stage becomes 1. Furthermore, because of the operational amplifier serves as the voltage follower or the impedance converter, the output voltage becomes constant.

With this construction, the output impedance of the output circuit of the CCD solid-state image pick-up device can be successfully lowered since the Burton circuit 60 serving as a buffer amplifier can avoid the influence of the voltage fluctuation. Furthermore, as the nature of the buffer amplifier employed in the shown circuit construction which allows to regulate the output voltage, a greater level margin can be given for the CCD solid-state image pick-up device. In other words, because the greater level margin can be given, lowering of the operation voltage level of the CCD solid-state image pick-up device becomes possible. Furthermore, since the output DC level can be held constant, circuit design with a fixed output voltage becomes possible to make designing easier. In addition, such circuit construction may give a wider signal dynamic range.

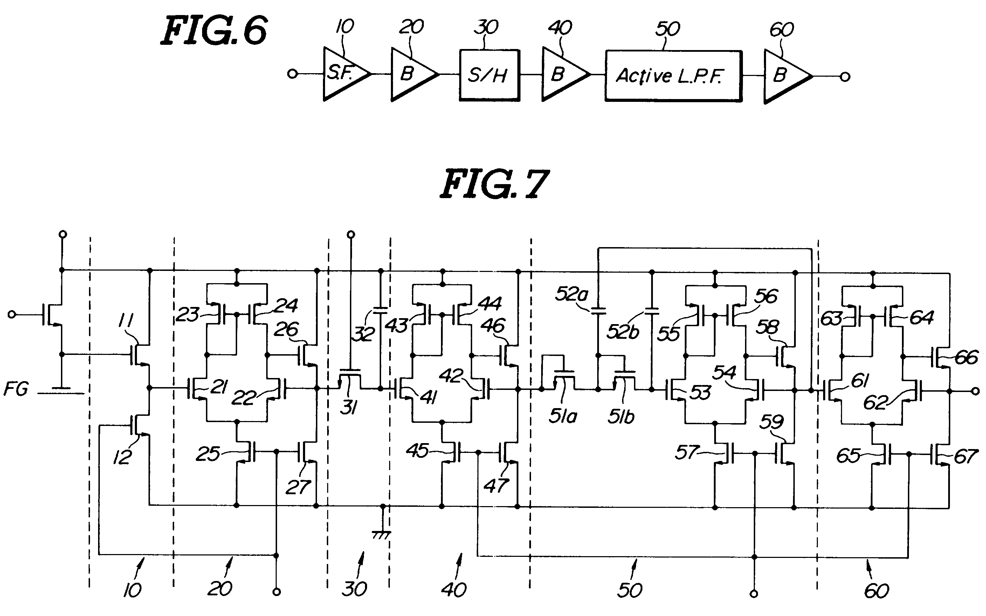

Figs. 6 and 7 show the third embodiment of the output stage of the CCD solid-state image pick-up device according to the invention. In this embodiment, a sample/hold circuit 30 is interposed between the Burton circuits 20 and 40. Namely, the source follower circuit 10, the Burton circuit 20, the sample/hold circuit 30, Burton circuit 40, the active low-pass filter circuit 50 and the Burton circuit 60 form a series circuit serving as the output state of the CCD solid-state image pick-up device, as shown in Fig. 6.

Fig. 7 shows the detailed circuit construction of the third embodiment of the circuit construction of the third embodiment of the circuit construction of the output stage of the CCD solid-state image pick-up device, according to the invention. The shown circuit construction is substantially the same as that of the foregoing second embodiment except for the sample hold circuit 30. Therefore, the following disclosure will be concentrated to the sample/hold circuit 30 and the associated circuit components in the already disclosed circuits in order to avoid unnecessary redundancy in recitation and to avoid possibility of confusion.

The sample/hold circuit 30 comprises a switching transistor 31 and a sample/holding capacitor 32. The switching transistor 31 has a gate connected to a sample/hold signal source to receive a sample/hold pulse. The source of the switching transistor 31 is connected to the output of the Burton circuit 20 to receive therefrom the output signal. The switching transistor 31 is turned ON and OFF by the sample/hold pulse for controlling charge and discharge of the capacitor 32.

In this case, the Burton circuit 20 provided at an input side of the switching transistor 31 of the sample/hold circuit 30 supplies a constant DC level of the output signal to the sample/hold circuit. On the other hand, the Burton circuit 40 provided at output side of the sample/hold circuit 30 regulates the output DC level of the output signal of the sample/hold circuit. Therefore, the operation of the active low-pass filter circuit 50 becomes stable.

While the present invention has been disclosed in terms of the preferred embodiment in order to facilitate better understanding of the invention, it should be appreciated that the invention can be embodied in various ways without departing from the principle of the invention. Therefore, the invention should be understood to include all possible embodiments and modifications to the shown embodiments which can be embodied without departing from the principle of the invention set out in the appended claims.

## Claims

1. An output circuit for a solid-state image pick-up device comprising:
an amplifier circuit (10) connected to the output of said solid-state image pick-up device for amplifying the output signal of said solid-state image pick-up device and a first buffer amplifier circuit (20) in voltage follower construction connected to the output of said amplifier circuit (10)
**characterized in**
that said first buffer amplifier circuit (20) has a gain substantially 1 and includes an operational amplifier (20A) with a positive and a negative input terminal, and a source follower circuit (20B) connected to the output of the operational amplifier (20A),
whereby the positive input terminal of the operational amplifier (20A) is connected to the output of said amplifier circuit (10) and the output signal from the source follower circuit (20B) is applied to the negative input terminal of the operational amplifier (20A) as a negative input so as to form a negative feedback loop.

2. An output circuit for a solid state image pick-up device as set forth in claim 1,
**characterized by**
further comprising a filter circuit (50) forming a series circuit with said amplifier (10).

3. An output circuit for a solid-state image pick-up device as set forth in claim 2,
**characterized in**
that said filter circuit (50) is an active low-pass filter.

4. An output circuit for a solid-state image pick-up device as set forth in any one of claims 1 to 3,
**characterized by**
further comprising a sample/hold circuit (30).

5. An output circuit for a solid-state image pick-up device as set forth in claim 2 or 3 which provides a second buffer amplifier circuit (60), which is connected to the output of said filter circuit (50), said first buffer amplifier circuit being connected between the output of said amplifier (10) and the input of said filter circuit (50).

6. An output circuit for a solid-state image pick-up device as set forth in claim 4, which provides a second buffer amplifier circuit (40), which is connected to the output side of said sample/hold circuit (30), said first buffer amplifier circuit being connected between the output of said amplifier (10) and the input of said sample/hold circuit (30).

7. An output circuit for a solid-state image pick-up device as set forth in claim 4, which provides a second and third buffer amplifier (40, 60), said first buffer amplifier circuit (20) being connected between the output of said amplifier (10) and the input of said sample/hold circuit (30), the input of said second buffer amplifier circuit (40) being connected to the output of said sample/hold circuit (30), and the output thereof being connected to said filter circuit (50), and input of said third buffer amplifier circuit (60) being connected to the output of said filter circuit (50).

8. An output circuit for a solid-state image pick-up device according to claim 1
**characterized in**
that said amplifier circuit (10) includes a NMOS transistor (11) having a gate connected to the output of said solid-state image pick-up device, and a drain connected to a power source, said NMOS transistor is switched between conductive state and non-conductive state by said output signal of said solid-state image pick-up device applied to said gate for outputting an output signal from the source of said NMOS transistor (11); and
said buffer amplifier circuit (20) includes first, second and third NMOS transistors (21, 22, 26) and first and second PMOS transistors (23, 24), said first NMOS transistor (21) has a gate connected to said source of said NMOS transistor (11) of said amplifier circuit (10), said first and second NMOS transistors (21, 22) and said first and second PMOS transistors (23, 24) are cooperative to each other for forming the operational amplifier (21-25) to output an output signal from the drain of said second NMOS transistor (22), said third NMOS transistor (26) has a gate connected to said drain of said second NMOS transistor (22) and a drain connected to the power source for outputting the output signal of said buffer amplifier (20) from the source thereof.

9. An output circuit for a solid-state image pick-up device as set forth in claim 8,
**characterized by**
further comprising an active low-pass filter circuit (50) forming a series circuit with said amplifier circuit (10), which active low-pass filter (50) includes first and second MOS transistors (51a, 51b) and first and second capacitors (52a, 52b), said first MOS transistor (51a) having a source connected to output of said buffer amplifier circuit (20) and a gate connected to the power source for controlling charging and discharging of said first capacitor (52a), said second MOS transistor (51b) having a source connected to a drain of said first MOS transistor (51a) and a gate connected to the power source for controlling charging and discharging of said second capacitor (52b), and said first and second MOS transistors (51a, 51b) and said first and second capacitors (52a, 52b) forming a time constant circuit.

10. An output circuit for a solid-state image pick-up device as set forth in claim 9,
**characterized by**
further comprising a second buffer amplifier circuit (40) connected to the input of said active low-pass filter circuit (50), said second buffer amplifier circuit (40) including fifth, sixth and seventh NMOS transistors (41, 42, 46) and third and forth PMOS transistors (43, 44), said fifth NMOS transistor (41) having a gate connected to receive output of said amplifier circuit (10), said fifth and sixth NMOS transistors (41, 42) and said third and fourth PMOS transistors (43, 44) being cooperative to each other for forming an operational amplifier to output an output signal from drain of said sixth NMOS transistor (42), said seventh NMOS transistor (46) having a gate connected to said drain of said sixth NMOS transistor (42) and a drain connected to the power source for outputting the output signal of said buffer amplifier (40) from the source thereof.

11. An output circuit for a solid-state image pick-up device as set forth in claim 9 or 10,
**characterized by**
futher comprising a third buffer amplifier circuit (60) provided at the output of said active low-pass filter circuit (50), said third buffer amplifier circuit (60) including eighth, nineth and tenth NMOS transistors (61, 62, 66) and fifth and sixth PMOS transistors (63, 64), said eighth NMOS transistor (61) having a gate connected to drain of said second MOS transistor (51b), said eighth and nineth NMOS transistors (61, 62) and said fifth and sixth PMOS transistors (63, 64) being cooperative to each other for forming an operational amplifier to output an output signal from drain of said nineth NMOS transistor (62), said tenth NMOS transistor (66) having a gate connected to said drain of said nineth NMOS transistor (62) and a drain connected to the power source for outputting the output signal of said third buffer amplifier (60) from the source thereof.

12. An output circuit for a solid-state image pick-up device as set fourth in anyone of claims 8 to 11,
**characterized by**
further comprising a sample/hold circuit (30) including a switching transistor (31) and a sample/hold capacitor (32), said switching transistor (31) having a source connected to output of said first buffer amplifier circuit (20) and a gate connected to a sample/hold pulse source.

## Patentansprüche

1. Ausgangsschaltung für eine Festkörperbildabtasteinrichtung, mit:
einer Verstärkerschaltung (10), die mit dem Ausgang der Festkörperbildabtasteinrichtung verbunden ist, um das Ausgangssignal der Festkörperbildabtasteinrichtung zu verstärken, und einer ersten Pufferverstärkerschaltung (20) als Spannungsfolger, die mit dem Ausgang der Verstärkerschaltung (10) verbunden ist
**dadurch gekennzeichnet, daß**
die erste Pufferverstärkerschaltung (20) einen Verstärkungsfaktor hat, der in etwa gleich 1 ist, und einen Operationsverstärker (20A) mit einem positiven und negativen Eingangsanschluß und eine Sourcefolger-Schaltung (20B) umfaßt, die mit dem Ausgang des Operationsverstärkers (20A) verbunden ist, wobei der positive Eingangsanschluß des Operationsverstärkers (20A) mit dem Ausgang der Verstärkerschaltung (10) verbunden ist, und das Ausgangssignal von der Sourcefolger-Schaltung (20B) an den negativen Eingangsanschluß des Operationsverstärkers (20A) als ein negatives Eingangssignal angelegt wird, um eine negative Rückführschleife zu bilden.

2. Ausgangsschaltung für eine Festkörperbildabtasteinrichtung nach Anspruch 1,
**dadurch gekennzeichnet,**
daß diese weiter eine Filterschaltung (50) aufweist, die eine Reihenschaltung mit dem Verstärker (10) bildet.

3. Ausgangsschaltung für eine Festkörperbildabtasteinrichtung nach Anspruch 2,
**dadurch gekennzeichnet,**
daß die Filterschaltung (50) ein Aktiv-Tiefpaßfilter ist.

4. Ausgangschaltung für eine Festkörperbildabtasteinrichtung nach einem der Ansprüche 1 bis 3,
**dadurch gekennzeichnet,**
daß sie außerdem eine Abtast-Halte-Schaltung (30) aufweist.

5. Ausgangsschaltung für eine Festkörperbildabtasteinrichtung nach Anspruch 2 oder 3, die eine zweite Pufferverstärkerschaltung (60) vorsieht, die mit dem Ausgang der Filterschaltung (50) verbunden ist, wobei die erste Pufferverstärkerschaltung zwischen dem Ausgang des Verstärkers (10) und dem Eingang der Filterschaltung (50) geschaltet ist.

6. Ausgangsschaltung für eine Festkörperbildabtasteinrichtung nach Anspruch 4, die eine zweite Pufferverstärkerschaltung (40) bereitstellt, die mit der Ausgangsseite der Abtast-Halte-Schaltung (30) verbunden ist, wobei die erste Pufferverstärkerschaltung zwischen dem Ausgang des Verstärkers (10) und dem Eingang der Abtast-Halte-Schaltung (30) geschaltet ist.

7. Ausgangsschaltung für eine Festkörperbildabtasteinrichtung nach Anspruch 4, die einen zweiten und dritten Pufferverstärker (40, 60) vorsieht, wobei die erste Pufferverstärkerschaltung (20) zwischen dem Ausgang des Verstärkers (10) und dem Eingang der Abtast-Halte-Schaltung (30) geschaltet ist, wobei der Eingang der zweiten Pufferverstärkerschaltung (40) mit dem Ausgang der Abtast-Halte-Schaltung (30) verbunden ist, und deren Ausgang mit der Filterschaltung (50) verbunden ist, und wobei der Eingang der dritten Pufferverstärkerschaltung (60) mit dem Ausgang der Filterschaltung (50) verbunden ist.

8. Ausgangsschaltung für eine Festkörperbildabtasteinrichtung nach Anspruch 1,
**dadurch gekennzeichnet, daß**
die Verstärkerschaltung (10) einen N-Kanal-MOS-Transistor (11) enthält, der ein Gate hat, das mit dem Ausgang der Festkörperbildabtasteinrichtung verbunden ist, und einen Drain, der mit einer Spannungsquelle verbunden ist, wobei der N-Kanal-MOS-Transistor zwischen einem leitenden Zustand und einem nichtleitenden Zustand durch das Ausgangssignal der Festkörperbildabtasteinrichtung umgeschaltet wird, welches an das Gate angelegt wird, um ein Ausgangssignal an der Source des N-Kanal-MOS-Transistors (11) auszugeben; und
die Pufferverstärkerschaltung (20) einen ersten, zweiten und dritten N-Kanal-MOS-Transistor (21, 22, 26) und einen ersten und zweiten P-Kanal-MOS-Transistor (23, 24) umfaßt, wobei der erste N-Kanal-MOS-Transistor (21) ein Gate hat, welches mit der Source des N-Kanal-MOS-Transistors (11) der Verstärkerschaltung (10) verbunden ist, wobei der erste und zweite N-Kanal-MOS-Transistor (21, 22) und der erste und zweite P-Kanal-MOS-Transistor (23, 24) funktionell miteinander in Zusammenhang stehen, um den Operationsverstärker (21 bis 25) zu bilden, um ein Ausgangssignal vom Drain des zweiten N-Kanal-MOS-Transistors (22) zu liefern, wobei der dritte N-Kanal-MOS-Transistor (26) ein Gate hat, welches mit dem Drain des zweiten N-Kanal-MOS-Transistors (22) verbunden ist, und einen Drain, der mit der Spannungsquelle verbunden ist, um das Ausgangssignal des Pufferverstärkers (20) an dessen Source auszugeben.

9. Ausgangsschaltung für eine Festkörperbildabtasteinrichtung nach Anspruch 8,
**dadurch gekennzeichnet, daß**
sie außerdem eine Aktiv-Tiefpaßfilterschaltung (50) besitzt, die eine Reihenschaltung mit der Verstärkerschaltung (10) bildet, wobei das Aktiv-Tiefpaßfilter (50) einen ersten und zweiten MOS-Transistor (51a, 51b) und einen ersten und zweiten Kondensator (52a, 52b) umfaßt, wobei der erste MOS-Transistor (51a) eine Source hat, die mit dem Ausgang der Pufferverstärkerschaltung (20) verbunden ist, und ein Gate, welches mit der Spannungsquelle verbunden ist, um das Laden und das Entladen des ersten Kondensators (52a) zu steuern, wobei der zweite MOS-Transistor (51b) eine Source hat, die mit dem Drain des ersten MOS-Transistors (51a) verbunden ist, und ein Gate, welches mit der Spannungsquelle verbunden ist, um das Laden und das Entladen des zweiten Kondensators (52b) zu steuern, und wobei der erste und zweite MOS-Transistor (51a, 51b) und der erste und zweite Kondensator (52a, 52b) eine Zeitkonstantenschaltung bilden.

10. Ausgangsschaltung für eine Festkörperbildabtasteinrichtung nach Anspruch 9,
**dadurch gekennzeichnet, daß**
sie außerdem eine zweite Pufferverstärkerschaltung (40) besitzt, die mit dem Eingang der Aktiv-Tiefpaßfilterschaltung (50) verbunden ist, wobei die zweite Pufferverstärkerschaltung (40) einen fünften, sechsten und siebten N-Kanal-MOS-Transistor (41, 42, 46) und einen dritten und vierten P-Kanal-MOS-Transistor (43, 44) umfaßt, wobei der fünfte N-Kanal-MOS-Transistor (41) ein Gate hat, welches geschaltet ist, um ein Ausgangssignal der Verstärkerschaltung (10) zu empfangen, wobei der fünfte und sechste N-Kanal-MOS-Transistor (41, 42) und der dritte und vierte P-Kanal-MOS-Transistor (43, 44) in funktionellem Zusammenhang miteinander stehen, um einen Operationsverstärker zu bilden, um ein Ausgangssignal am Drain des sechsten N-Kanal-MOS-Transistors (42) zu liefern, wobei der siebte N-Kanal-MOS-Transistor (46) ein Gate hat, welches mit dem Drain des sechsten N-Kanal-MOS-Transistors (42) verbunden ist, und einen Drain, der mit der Spannungsquelle verbunden ist, um das Ausgangssignal des Pufferverstärkers (40) an dessen Source zu liefern.

11. Ausgangsschaltung für eine Festkörperbildabtasteinrichtung nach Anspruch 9 oder 10,
**dadurch gekennzeichnet, daß**
sie weiter eine dritte Pufferverstärkerschaltung (60) umfaßt, die am Ausgang der Aktiv-Tiefpaßfilterschaltung (50) vorgesehen ist, wobei die dritte Pufferverstärkerschaltung (60) einen achten, neunten und zehnten N-Kanal-MOS-Transistor (61, 62, 66) und einen fünften und sechsten P-Kanal-MOS-Transistor (63, 64) aufweist, wobei der achte N-Kanal-MOS-Transistor (61) ein Gate hat, welches mit dem Drain des zweiten MOS-Transistors (51b) verbunden ist, wobei der achte und neunte N-Kanal-MOS-Transistor (61, 62) und der fünfte und sechste P-Kanal-MOS-Transistor (63, 64) miteinander in funktionellem Zusammenhang stehen, um einen Operationsverstärker zu bilden, um ein Ausgangssignal am Drain des neunten N-Kanal-MOS-Transistors (62) zu liefern, wobei der zehnte N-Kanal-MOS-Transistor (66) ein Gate hat, welches mit dem Drain des neunten N-Kanal-MOS-Transistors (62) verbunden ist, und einen Drain, der mit der Spannungsquelle verbunden ist, um das Ausgangssignal des dritten Pufferverstärkers (60) an dessen Source zu liefern.

12. Ausgangsschaltung für eine Festkörperbildabtasteinrichtung nach einem der Ansprüche 8 bis 11,
**dadurch gekennzeichnet, daß**
diese außerdem eine Abtast-Halte-Schaltung (30) aufweist, die einen Schalttransistor (31) und einen Abtast-Halte-Kondensator (32) aufweist, wobei der Schalttransistor (31) eine Source hat, die mit dem Ausgang der ersten Pufferverstärkerschaltung (20) verbunden ist, und ein Gate, welches mit einer Abtast-Halte-Impulsquelle verbunden ist.

## Revendications

1. Circuit de sortie pour un dispositif de lecture d'image à semi-conducteur CCD comprenant :
un circuit d'amplificateur (10) raccordé à la sortie dudit dispositif de lecture d'image à semi-conducteur CCD pour amplifier le signal de sortie dudit dispositif de lecture d'image à semi-conducteur CCD et un premier circuit d'amplificateur à tampon (20) sous forme de suiveur de tension raccordé à la sortie dudit circuit d'amplificateur (10);
circuit caractérisé en ce que ledit premier circuit d'amplificateur à tampon (20) présente un gain pratiquement unitaire et comprend un amplificateur opérationnel (20A) avec une borne d'entrée positive et une borne d'entrée négative, et un circuit suiveur de tension (20B) raccordé à la sortie de l'amplificateur opérationnel (20A), la borne d'entrée positive de l'amplificateur opérationnel (20A) étant ainsi raccordée à la sortie dudit circuit d'amplificateur (10) et le signal de sortie du circuit suiveur de tension (20B) étant appliqué à la borne d'entrée négative de l'amplificateur opérationnel (20A) comme entrée négative de façon à former une boucle de rétroaction négative.

2. Circuit de sortie pour un dispositif de lecture d'image à semi-conducteur selon la revendication 1, caractérisé en ce qu'il comprend, de plus, un circuit de filtre (50) formant un circuit en série avec ledit circuit d'amplificateur (10).

3. Circuit de sortie pour un dispositif de lecture d'image à semi-conducteur selon la revendication 2, caractérisé en ce que ledit circuit de filtre (50) est un filtre passe-bas actif.

4. Circuit de sortie pour un dispositif de lecture d'image à semi-conducteur selon l'une quelconque des revendications 1 à 3, caractérisé en ce qu'il comprend, de plus, un circuit d'échantillonnage/ maintien (30).

5. Circuit de sortie pour un dispositif de lecture d'image à semi-conducteur selon la revendication 2 ou 3, constituant un second circuit d'amplificateur à tampon (60) raccordé à la sortie dudit circuit de filtre (50), ledit premier circuit d'amplificateur à tampon (20) étant monté entre la sortie dudit circuit d'amplificateur (10) et l'entrée dudit circuit de filtre (50).

6. Circuit de sortie pour un dispositif de lecture d'image à semi-conducteur selon la revendication 4, constituant un second circuit d'amplificateur à tampon (40) raccordé au côté de sortie dudit circuit d'échantillonnage/maintien (30), ledit premier circuit d'amplificateur à tampon (20) étant monté entre la sortie dudit circuit d'amplificateur (10) et l'entrée dudit circuit d'échantillonnage/maintien (30).

7. Circuit de sortie pour un dispositif de lecture d'image à semi-conducteur selon la revendication 4, constituant un second et troisième amplificateur à tampon (40, 60), ledit premier circuit d'amplificateur à tampon (20) étant monté entre la sortie dudit circuit d'amplificateur (10) et l'entrée dudit circuit d'échantillonnage/maintien (30), l'entrée dudit second circuit d'amplificateur à tampon (40) étant raccordée à la sortie dudit circuit d'échantillonnage et de maintien (30) et sa sortie étant raccordée audit circuit de filtre (50), et l'entrée dudit troisième circuit d'amplificateur à tampon (60) étant raccordée à la sortie dudit circuit de filtre (50).

8. Circuit de sortie pour un dispositif de lecture d'image à semi-conducteur selon la revendication 1, caractérisé en ce que ledit circuit d'amplificateur (10) comprend un transistor NMOS (11) possédant une grille raccordée à la sortie dudit dispositif de lecture d'image à semi-conducteur, et un drain raccordé à une source de puissance, ledit transistor NMOS (11) étant commuté entre un état passant et un état bloqué par ledit signal de sortie dudit dispositif de lecture d'image à semi-conducteur appliqué à ladite grille pour fournir un signal de sortie de la source dudit transistor NMOS (11); et
ledit premier circuit d'amplificateur à tampon (20) comprend des premier, second et troisième transistors NMOS (21, 22, 26) et des premier et second transistors PMOS (23, 24), ledit premier transistor NMOS (21) possède une grille raccordée à ladite source dudit transistor NMOS (11) dudit circuit d'amplificateur (10), lesdits premier et second transistors NMOS (21, 22) et lesdits premier et second transistors PMOS (23, 24) coopèrent pour former un amplificateur opérationnel (21 à 25) pour fournir un signal de sortie du drain dudit second transistor NMOS (22), ledit troisième transistor NMOS (26) possède une grille raccordée audit drain dudit second transistor NMOS (22) et un drain raccordé à la source de puissance pour fournir le signal de sortie dudit premier circuit d'amplificateur à tampon (20) à partir de sa source.

9. Circuit de sortie pour un dispositif de lecture d'image à semi-conducteur selon la revendication 8, caractérisé en ce qu'il comprend, de plus, un circuit de filtre (50) formant un circuit en série avec ledit circuit d'amplificateur (10), circuit de filtre (50) comprenant des premier et second transistor MOS (51a, 51b) et des premier et second condensateurs (52a, 52b), ledit premier transistor MOS (51a) possédant une source raccordée à la sortie dudit premier circuit d'amplificateur à tampon (20) et une grille raccordée à la source de puissance pour commander la charge et la décharge dudit premier condensateur (52a), ledit second transistor MOS (51b) possédant une source raccordée à un drain dudit premier transistor MOS (51a) et une grille raccordée à la source de puissance pour commander la charge et la décharge dudit second condensateur (52b), lesdits premier et second transistors MOS (51a et 51b) et lesdits premier et second condensateurs (52a, 52b) formant un circuit à constante de temps.

10. Circuit de sortie pour un dispositif de lecture d'image à semi-conducteur selon la revendication 9, caractérisé en ce qu'il comprend, de plus, un second circuit d'amplificateur à tampon (40) raccordé à l'entrée dudit circuit actif de filtre passe-bas (50), ledit second circuit d'amplificateur à tampon (40) comprenant des cinquième, sixième et septième transistors NMOS (41, 42, 46) et des troisième et quatrième transistors PMOS (43, 44), ledit cinquième transistor NMOS (41) possédant une grille raccordée pour recevoir la sortie dudit circuit d'amplificateur (10), lesdits cinquième et sixième transistors NMOS (41, 42) et lesdits troisième et quatrième transistors PMOS (43, 44) coopérant pour former un amplificateur opérationnel pour générer un signal de sortie du drain dudit sixième transistor NMOS (42), ledit septième transistor NMOS (46) possédant une grille raccordée audit drain dudit sixième transistor NMOS (42) et un drain raccordé à la source de puissance pour fournir le signal de sortie dudit second circuit d'amplificateur à tampon (40) à partir de sa source.

11. Circuit de sortie pour un dispositif de lecture d'image à semi-conducteur selon la revendication 9 ou 10, caractérisé en ce qu'il comprend, de plus, un troisième circuit d'amplificateur à tampon (60) prévu sur la sortie dudit circuit actif de filtre passe-bas (50), ledit troisième circuit d'amplificateur à tampon (60) comprenant des huitième, neuvième et dixième transistors NMOS (61, 62, 66) et des cinquième et sixième transistors PMOS (63, 64), ledit huitième transistor NMOS (61) possédant une grille raccordée au drain dudit second transistor MOS (51b), lesdits huitième et neuvième transistors NMOS (61, 62) et lesdits cinquième et sixième transistors PMOS (63, 64) coopérant pour former un amplificateur opérationnel générant un signal de sortie du drain dudit neuvième transistor NMOS (62), ledit dixième transistor NMOS (66) possédant une grille raccordée audit drain dudit neuvième transistor NMOS (62) et un drain raccordé à la source de puissance pour générer le signal de sortie dudit troisième circuit d'amplificateur à tampon (60) à partir de sa source.

12. Circuit de sortie pour un dispositif de lecture d'image à semi-conducteur selon l'une quelconque des revendications 8 à 11, caractérisé en ce qu'il comprend, de plus, un circuit d'échantillonnage et de maintien (30) comprenant un transistor de commutation (31) et un condensateur d'échantillonnage/ maintien (32), ledit transistor de commutation (31) possédant une source raccordée à la sortie dudit premier circuit d'amplificateur à tampon (20) et une grille raccordée à une source d'impulsion d'échantillonnage et de maintien.
